# EUROPÄISCHE PATENTSCHRIFT

(11) **EP 2 417 053 B1**
(45) Veröffentlichungstag und Bekanntmachung des Hinweises auf die Patenterteilung: **27.05.2015**
(21) Anmeldenummer: 09776537.4
(22) Anmeldetag: 07.04.2009
(51) Int. Cl.: B81B 3/00, G01H 11/06, G01P 15/125, G01P 15/08

(54) **MIKROMECHANISCHES SYSTEM MIT SEISMISCHER MASSE**
MICROMECHANICAL SYSTEM HAVING SEISMIC MASS
SYSTÈME MICROMÉCANIQUE AYANT MASSE SISMIQUE

(43) Veröffentlichungstag der Anmeldung: 15.02.2012
(73) Patentinhaber: Siemens Aktiengesellschaft, 80333 München (DE)
(72) Erfinder: FORKE, Roman, 09126 Chemnitz (DE); SCHEIBNER, Dirk, 90473 Nürnberg (DE); SHAPORIN, Alexey, 09126 Chemnitz (DE)
(86) Internationale Anmeldenummer: PCT/EP2009/002773
(87) Internationale Veröffentlichungsnummer: WO 2010/115445

(56) Entgegenhaltungen:
- WO-A-02/12906
- US-A1- 2004 025 591
- US-A1- 2006 261 915
- FORKE ET AL: "Electrostatic force coupling of MEMS oscillators for spectral vibration measurements" SENSORS AND ACTUATORS A, ELSEVIER SEQUOIA S.A., LAUSANNE, CH, Bd. 142, Nr. 1, 5. Februar 2008 (2008-02-05), Seiten 276-283, XP022455422 ISSN: 0924-4247

## Beschreibung

Mikromechanische Systeme, die häufig auch als Mikrosysteme oder MEMS (Micro-Electro-Mechanical-System) bezeichnet werden, finden insbesondere aufgrund ihrer geringen Größe, ihres vergleichsweise geringen Preises sowie ihrer hohen Zuverlässigkeit zunehmend Verbreitung. Dies betrifft beispielsweise die Verwendung mikromechanischer Systeme als Aktoren oder Sensoren, etwa in Form von Sensoren zur Erfassung von Schallemissionen, Körperschall-, Beschleunigungs- und Neigungssensoren, Drehratesensoren oder Drucksensoren.

Unter "Schallemissionen", die im englischsprachigen als "Acoustic Emissions (AE)" bezeichnet werden, wird üblicherweise eine Erscheinung verstanden, bei der elastische Wellen durch eine stoßartige Anregung aufgrund einer plötzlichen Freisetzung von Energie innerhalb eines Festkörpers erzeugt werden. Entsprechende Schallemissionssignale, die sich in Form von Körperschall in dem Festkörper ausbreiten, treten üblicherweise in einem Frequenzbereich von etwa 20 kHz bis zu etwa 1 MHz auf. Dabei weisen Schallemissionssignale eine hohe Sensitivität in Bezug auf mechanische Beschädigungen eines Festkörpers beziehungsweise eines Objektes auf. Daher werden mikromechanische Sensoren zur Erfassung von Schallemissionen (Acoustic Emission Sensors) insbesondere zur Verschleißüberwachung mechanischer Bauteile wie beispielsweise Wälzlager eingesetzt. Entsprechende Sensoren weisen üblicherweise ein schwingfahiges System mit einer an Federelementen aufgehängten beziehungsweise befestigten seismischen Masse auf. Äußere Kräfte beziehungsweise Beschleunigungen bewirken eine Auslenkung der seismischen Masse gegenüber feststehenden Ankerpunkten etwa in Form fester Aufhängungen. Diese relative Bewegung wird ausgewertet, wobei zur Signalgewinnung häufig ein kapazitives Prinzip angewendet wird. Hierbei weist die seismische Masse Elektrodenanordnungen auf, die beispielsweise kammartig ausgeführt sein können und zusammen mit einer feststehenden Gegenelektrode eine variable Kapazität bilden. Über eine Erfassung des Wertes der Kapazität beziehungsweise ihrer Änderung ist hierbei eine Detektion von Schallemissionen möglich.

Die vorliegende Erfindung betrifft ein mikromechanisches System mit einem schwingfähigen System, das eine seismische Masse sowie zumindest zwei Federelemente aufweist, wobei die Federelemente jeweils derart einerseits außen an die seismische Masse und andererseits an feststehende Ankerpunkte des mikromechanischen Systems angebunden sind, dass eine Schwingung der seismischen Masse in einer Bewegungsrichtung ermöglicht wird. Dabei bedeutet "in einer Bewegungsrichtung", dass das schwingfähige System genau einen linearen Freiheitsgrad aufweist, d.h. dass eine Bewegung des schwingfähigen Systems im Betrieb des mikromechanischen Systems nur in genau eine Richtung, die Bewegungsrichtung, vorgesehen ist.

Ein solches mikromechanisches System ist aus dem Kapitel "System-Level Synthesis" in "Optimal Synthesis Methode for MEMS", Ananthasuresh, G. K. (Hrsg.), Springer, 2003, S. 297-316 bekannt.

Derzeit zeigt sich ein Trend zu immer höheren Eigenfrequenzen mikromechanischer Systeme. Dies gilt sowohl für breitbandige Anwendungen als auch für resonante, d.h. in Resonanz betriebene, Systeme. Neben den bereits erwähnten Sensoren zur Erfassung von Schallemissionen seien hier als weitere Beispiele mikromechanische Filter und Mixer für den Hochfrequenzbereich genannt.
Mikromechanische Systeme mit schwingfähigen Systemen werden häufig im Bereich einer Resonanzfrequenz, d.h. im Bereich einer durch eine entsprechende Eigenfrequenz bestimmten Eigenmode, betrieben. Dabei wird die Frequenz beziehungsweise die mit dieser Frequenz verbundene Schwingform, für die das schwingfähige System hinsichtlich seines Betriebs ausgebildet beziehungsweise vorgesehen ist, auch als Nutzmode bezeichnet. Bei einem resonanten Betrieb handelt es sich bei der Nutzmode somit um eine Eigenmode, in der Regel die erste Eigenmode, des schwingfähigen Systems. Die Schwingungsmoden höherer Eigenfrequenzen können dabei zu unerwünschten Effekten führen, wie beispielsweise überlagerten Störsignalen oder einer verringerung der Empfindlichkeit. Aus diesem Grund ist allgemein ein großer Frequenzabstand, d.h. eine Moden-Separation, zwischen der Nutzmode und den weiteren Schwingungsmoden, insbesondere den weiteren Eigenmoden, des schwingfähigen Systems wünschenswert.

Bei resonanten mikromechanischen Systemen, wie sie beispielsweise für Sensoren zur Erfassung von Schallemissionssignalen genutzt werden, wird üblicherweise eine hohe Steifigkeit des schwingfähigen Systems in der Bewegungs- beziehungsweise Nutzrichtung gefordert. Darüber hinaus wird zur Vermeidung von aus der vorgesehenen Bewegungsrichtung heraus gerichteten Bewegungen in der Regel eine nochmals deutlich höhere Steifigkeit quer zur Bewegungsrichtung angestrebt. Andererseits werden großflächige Elektroden beziehungsweise Elektrodensysteme benötigt, um eine ausreichend große Empfindlichkeit des mikromechanischen Systems zu erhalten. Entsprechende Elektroden führen nun jedoch zu einer Beeinflussung des dynamischen Verhaltens des mikromechanischen Systems und es besteht die Gefahr, dass die weiteren Eigenmoden des schwingfähigen Systems bereits in einem vergleichsweise kleinen Frequenzabstand zur Nutzmode (die wie zuvor bereits erwähnt in der Regel der Hauptmode, d.h. der ersten Eigenmode, entspricht) auftreten. Dabei kann die Vorzugsrichtung entsprechender höherer Schwingungsmoden sowohl innerhalb der durch das mikromechanische System aufgespannten Ebene liegen als auch aus dieser Ebene heraus weisen. Schwingungsmoden der zuletzt genannten Art treten insbesondere bei flächigen Strukturen auf und werden üblicherweise als "Membran-Moden" beziehungsweise "Out-Of-Plane-Moden" bezeichnet.

Grundsätzlich könnte eine Maßnahme zur Vergrößerung des Frequenzabstands zwischen den Schwingungsmoden des schwingfähigen Systems des mikromechanischen Systems darin bestehen, die Strukturdicke des mikromechanischen Systems zu vergrößern. Dies ist mit den bekannten Trockenätz-Prozessen jedoch nicht ohne weiteres möglich. Darüber hinaus wäre hierdurch lediglich eine Verbesserung der Separation der "Out-of-Plane-Moden" von den "In-Plane-Moden" des schwingfähigen Systems möglich.

Aus der zuvor genannten Druckschrift "System-Level Synthesis" ist es ferner bekannt, eine Verbesserung des Abstands zwischen Eigenmoden eines schwingfähigen Systems dadurch zu erzielen, dass die Anzahl der Elektroden verringert wird. Dies weist jedoch den Nachteil auf, dass hierdurch in der Regel gleichzeitig die Empfindlichkeit des mikromechanischen Systems deutlich verringert wird.

Aus der US 2006/0261915 A1 ist bereits ein mikromechanisches System bekannt, mit einer seismischen Masse und Federelementen die über feststehende Ankerpunkte angebunden sind. Die Masse kann senkrecht zur Ebene zumindest mit kleinen Amplituden schwingen. Es ist weiterhin bekannt ein weiteres Federelement mittels dessen die seismische Masse an einem weiteren Angkerpunkt angebunden ist.Der vorliegenden Erfindung liegt die Aufgabe zugrunde, ein mikromechanisches System mit einem schwingfähigen System, das eine seismische Masse sowie zumindest zwei Federelemente aufweist, wobei die Federelemente jeweils derart einerseits außen an die seismische Masse und andererseits an feststehende Ankerpunkte des mikromechanischen Systems angebunden sind, dass eine Schwingung der seismischen Masse in einer Bewegungsrichtung ermöglicht wird, anzugeben, dessen Nutzmode einen besonders großen Frequenzabstand zu weiteren auftretenden Schwingungsmoden des schwingfähigen Systems aufweist.

Diese Aufgabe wird erfindungsgemäß gelöst durch ein mikromechanisches System mit einem schwingfähigen System, das eine seismische Masse sowie zumindest zwei Federelemente aufweist, wobei die Federelemente jeweils derart einerseits außen an die seismische Masse und andererseits an feststehende Ankerpunkte des mikromechanischen Systems angebunden sind, dass eine Schwingung der seismischen Masse in einer Bewegungsrichtung ermöglicht wird, wobei im Innenbereich der seismischen Masse zumindest ein weiteres Federelement vorgesehen ist, mittels dessen die seismische Masse an einen weiteren Ankerpunkt des mikromechanischen Systems angebunden ist, wobei das mikromechanische System als Sensor zur Erfassung von Schallemissionssignalen ausgebildet ist.

Das erfindungsgemäße mikroelektromechanische System ist vorteilhaft, da das im Innenbereich der seismischen Masse zusätzlich vorgesehene mindestens eine Federelement eine Veränderung des dynamischen Verhaltens des schwingfähigen Systems derart ermöglicht, dass der Frequenzabstand zwischen den Eigenmoden des schwingfähigen Systems, insbesondere zwischen der Nutzmode, d.h. beispielsweise der ersten Eigenmode, und den weiteren Eigenmoden, optimiert wird. Dies kann einerseits dadurch geschehen, dass bestimmte Resonanzen, d.h. bestimmte Eigenmoden, höherer Frequenz vollständig unterdrückt werden oder dass der Frequenzabstand zwischen der Frequenz der Nutzmode und den Frequenzen weiterer auftretender Eigenmoden vergrößert wird. Ein grundlegender Vorteil des erfindungsgemäßen mikromechanischen Systems besteht dabei darin, dass die Empfindlichkeit des mikromechanischen Systems beziehungsweise des schwingfähigen Systems des mikromechanischen Systems von der Optimierung nicht beeinflusst wird und somit unverändert bleibt. Gemäß einer besonders bevorzugten Weiterbildung ist das erfindungsgemäße mikromechanische System derart ausgestaltet, dass das schwingfähige System eine Resonanzfrequenz im Ultraschallbereich aufweist. Dies ist vorteilhaft, da insbesondere bei Schwingungs- beziehungsweise Eigenmoden mit Resonanzfrequenzen im Ultraschallbereich ein ausreichender Frequenzabstand der von dem mikromechanischen System im Betrieb verwendeten Nutzmode von weiteren Schwingungsmoden, insbesondere Eigenmoden, des mikromechanischen Systems erforderlich ist.

Grundsätzlich können die Federelemente des schwingfähigen Systems in beliebiger Art und Weise ausgebildet sein. Gemäß einer weiteren besonders bevorzugten Ausführungsform des erfindungsgemäßen mikromechanischen Systems sind die Federelemente als Bügelfedern ausgebildet. Dies bietet den Vorteil, dass hierdurch im Falle einer Auslenkung der Federn eine Versteifung derselben in Folge des so genannten "Stress-Stiffening-Effektes" vermieden wird. Darüber hinaus wird die Quersteifigkeit dahingehend erhöht, dass von der vorgesehenen Bewegungsrichtung abweichende Bewegungen zusätzlich unterdrückt werden.

Vorzugsweise kann das erfindungsgemäße mikromechanische System auch derart weitergebildet sein, dass das zumindest eine weitere Federelement als Bügelfeder ausgebildet ist. Entsprechend den vorherigen Ausführungen ist auch die Verwendung einer Bügelfeder als weiteres Federelement dahingehend vorteilhaft, dass hierdurch eine Versteifung des weiteren Federelementes unter Belastung vermieden und die Quersteifigkeit des schwingfähigen Systems erhöht wird.

Bei dem mikromechanischen System kann es sich um ein für beliebige, für sich bekannte Anwendungen vorgesehenes System handeln. Dies schließt beispielsweise Aktoren unterschiedlicher Art ein. Gemäß einer weiteren besonders bevorzugten Ausgestaltung ist das erfindungsgemäße mikromechanische System als Sensor ausgebildet. Dies ist vorteilhaft, da mikromechanische Sensoren aufgrund ihres vergleichsweise geringen Preises sowie ihrer hohen Zuverlässigkeit zunehmend für unterschiedliche Anwendungen verwendet werden.

Gemäß einer weiteren besonders bevorzugten Ausführungsform ist das erfindungsgemäße mikromechanische System als Sensor zur Erfassung von Schallemissionssignalen ausgebildet. Dies ist vorteilhaft, da Sensoren zum Erfassen von Schallemissionen (Acoustic Emission) in der Regel Schwingungen oberhalb des hörbaren Bereichs, d.h. beispielsweise im Ultraschallbereich, detektieren. Wie zuvor bereits erläutert, ist hier eine ausreichende Separation der für den Betrieb des mikromechanischen Systems verwendeten Nutzmode, d.h. in der Regel der ersten Schwingungsbeziehungsweise Eigenmode, von den weiteren Schwingungsmoden des schwingfähigen Systems des mikromechanischen Systems besonders wünschenswert.

Im Folgenden wird die Erfindung anhand von Ausführungsbeispielen näher erläutert. Hierzu zeigt
- Figur 1: in einer schematischen Skizze ein herkömmliches mikromechanisches System mit einem schwingfähigen System,
- Figur 2: in einer schematischen Skizze ein erstes Ausführungsbeispiel des erfindungsgemäßen mikromechanischen Systems,
- Figur 3: das Frequenzspektrum des herkömmlichen mikromechanischen Systems gemäß Figur 1,
- Figur 4: das Frequenzspektrum des erfindungsgemäßen mikromechanischen Systems gemäß dem Ausführungsbeispiel der Figur 2,
- Figur 5: in einer schematischen Skizze ein weiteres Ausführungsbeispiel des erfindungsgemäßen mikromechanischen Systems und
- Figur 6: Ausführungsbeispiele weiterer Federelemente des erfindungsgemäßen mikromechanischen Systems.

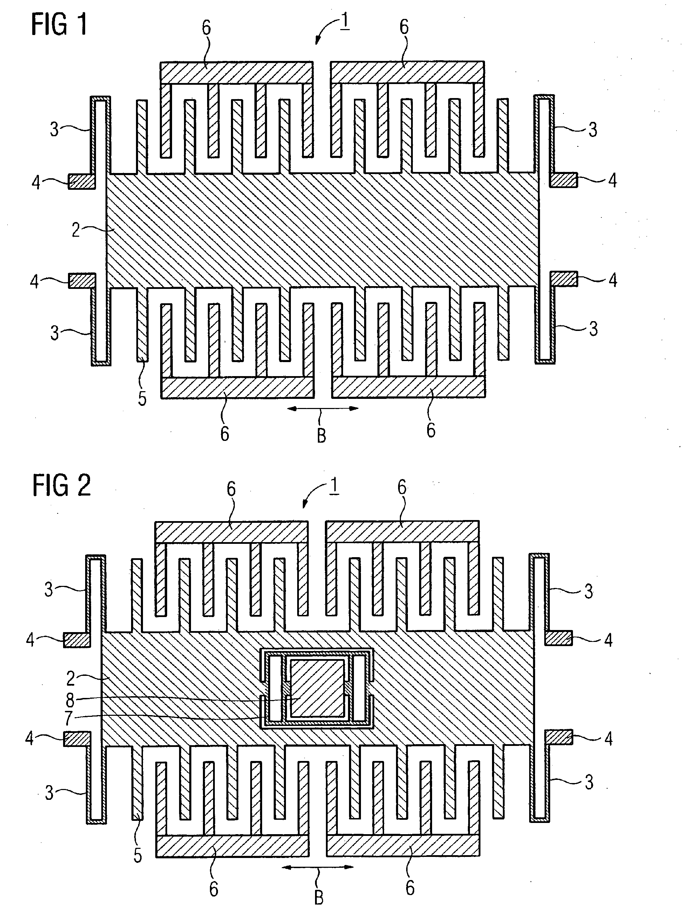

Aus Gründen der Übersichtlichkeit werden in den Figuren für gleiche beziehungsweise gleich wirkende Komponenten identische Bezugszeichen verwendet. Darüber hinaus sei angemerkt, dass in den Figuren 1, 2, 5 und 6 jeweils eine Draufsicht der jeweiligen Struktur gezeigt ist.

Figur 1 zeigt in einer schematischen Skizze ein herkömmliches mikromechanisches System mit einem schwingfähigen System. Gezeigt ist ein mikromechanisches System 1 mit einem schwingfähigen System, das eine seismische Masse 2 sowie vier Federelemente 3 aufweist. Entsprechend der Darstellung in Figur 1 sind die Federelemente 3 dabei einerseits außen an die seismische Masse 2 angebunden. Darüber hinaus sind die Federelemente 3 andererseits an feststehende Ankerpunkte 4 des mikromechanischen Systems angebunden. Dabei ist der Aufbau des schwingfähigen Systems derart, dass eine Schwingung der seismischen Masse 2 ausschließlich in einer horizontalen Bewegungsrichtung B ermöglicht wird.

Neben den zuvor genannten Elementen weist das mikromechanische System 1 eine bewegliche Elektrode 5 auf, die kammartig ausgebildet ist. Aus Gründen der Übersichtlichkeit ist hierbei in Figur 1 lediglich eines der balkenförmigen Elemente der beweglichen Elektrode mit dem entsprechenden Bezugszeichen gekennzeichnet.

Die balkenförmigen Elemente der beweglichen Elektrode 5 greifen in entsprechende Elemente einer als Gegenelektrode wirkenden festen Elektrode 6. Eine Anregung des schwingfähigen Systems beispielsweise durch mechanische Schwingungen bewirkt eine Änderung der Kapazität des mikromechanischen Systems 1, so dass eine entsprechende Änderung der Kapazität zur Detektion von Schwingungen herangezogen werden kann. Bei entsprechenden Schwingungen kann es sich beispielsweise um im Rahmen des Betriebs eines Wälzlagers entstehende Schallemissionssignale handeln, die sich in einem Festkörper als Körperschall ausbreiten und mittels des mikromechanischen Systems 1 erfasst werden.

Das in Figur 1 dargestellte herkömmliche mikromechanische System 1 weist den Nachteil auf, dass die weiteren Schwingungsmoden beziehungsweise Eigenmoden bereits in einem vergleichsweise kleinen Frequenzabstand zur Hauptmode beziehungsweise ersten Eigenmode auftreten. In Abhängigkeit von den jeweiligen Gegebenheiten kann dabei die Vorzugsrichtung der entsprechenden Eigenmoden höherer Frequenz sowohl in der Ebene der Struktur, d.h. in der Draufsicht der Figur 1 in der der Blatt- beziehungsweise Zeichnungsebene entsprechenden Wafer-Ebene, verlaufen als auch aus dieser Ebene heraus gerichtet sein.

Figur 2 zeigt in einer schematischen Skizze ein erstes Ausführungsbeispiel des erfindungsgemäßen mikromechanischen Systems. Während die übrigen Komponenten des mikromechanischen Systems 1 der Figur 2 denjenigen der Figur 1 entsprechen, weist das erfindungsgemäße mikromechanische System 1 gemäß Figur 2 vorteilhafterweise im Innenbereich der seismischen Masse 2 zusätzlich ein weiteres Federelement 7 auf, mittels dessen die seismische Masse 2 an einen weiteren Ankerpunkt 8 des mikromechanischen Systems 1 angebunden ist. Dies ist vorteilhaft, da mittels des weiteren Federelementes 7 eine gezielte Beeinflussung des dynamischen Verhaltens des mikromechanischen Systems 1 beziehungsweise des schwingfähigen Systems des mikromechanischen Systems 1 ermöglicht wird. Hierdurch wird eine gezielte Unterdrückung höherer Eigenschwingformen beziehungsweise eine Vergrößerung der Moden-Separa-tion, d.h. insbesondere eine Vergrößerung des Frequenzabstandes zwischen der Nutzmode und den weiteren Eigenmoden des schwingfähigen Systems, erreicht. Letztlich bewirkt das zusätzlich vorgesehene weitere Federelement 7 somit eine Versteifung störender beziehungsweise unerwünschter Schwingungsmoden des mikromechanischen Systems 1, wobei die Empfindlichkeit des mikromechanischen Systems 1 hierbei vorteilhafterweise unverändert bleibt. Dabei verhindert die Ausführung des weiteren Federelementes 7 als Bügelfeder vorteilhafterweise eine auslenkungsbedingte Versteifung des weiteren Federelementes 7 aufgrund des so genannten "Stress-Stiffening-Effekts".

Konkret kann das mikromechanische System 1 der Figur 2 beispielsweise derart erstellt beziehungsweise hinsichtlich seines Aufbaus entworfen beziehungsweise entwickelt werden, dass nach einem ersten Entwurf des mikromechanischen Systems eine Modalanalyse mit Hilfe von für sich bekannten computergestützten Simulationsmodellen gemäß einer Finite-Elemente-Methode (FEM) erfolgt. Durch die Modalanalyse ergibt sich ein Überblick über die höheren Schwingungsmoden des mikromechanischen Systems 1. Bei solchen höheren Schwingungsmoden handelt es sich häufig um aus der Wafer-Ebene heraus gerichtete "Out-Of-Plane"-Bewegungen, während die eigentliche Nutzmode entsprechend den vorstehenden Ausführungen eine laterale Bewegung des schwingfähigen Systems des mikromechanischen Systems in die Bewegungsrichtung darstellt.

Mittels der Analyse der Schwingungsmoden des schwingfähigen Systems wird nun im Innenbereich der seismischen Masse 2 zumindest eine Stelle ermittelt, an der eine Schwingungsamplitude senkrecht zur Bewegungsrichtung B auftritt. Vorteilhafterweise wird hierbei die Stelle ermittelt, an der die größte entsprechende vertikale Amplitude auftritt. Unter Berücksichtigung der technologischen Realisierbarkeit wird an dieser Stelle gezielt zumindest ein weiteres Federelement 7 vorgesehen, mittels dessen die seismische Masse 2 an den weiteren Ankerpunkt 8 des mikromechanischen Systems 1 angebunden wird. Somit wird mittels des weiteren Federelementes 7 und dem weiteren Ankerpunkt 8 eine weitere Lagerung beziehungsweise eine weitere Aufhängung der seismischen Masse 2 realisiert.

Im Folgenden wird vorteilhafterweise die Gesamtfedersteifigkeit des schwingfähigen Systems des mikromechanischen Systems 1 derart angepasst, dass sie wieder dem ursprünglichen Wert entspricht. Somit werden im Ergebnis lediglich die höheren Frequenzen beziehungsweise Eigenmoden des schwingfähigen Systems unterdrückt oder zu höheren Frequenzen hin verschoben. Die Frequenz der Nutzmode bleibt hierbei vorzugsweise jedoch unverändert.

Die zuvor genannten Schritte können vorteilhafterweise im Rahmen einer Iteration so lange wiederholt werden, bis sich ein Optimum einstellt. Dabei erfolgt eine Realisierung des gesamten beschriebenen Verfahrens vorzugsweise computergestützt, d.h. softwarebasiert.

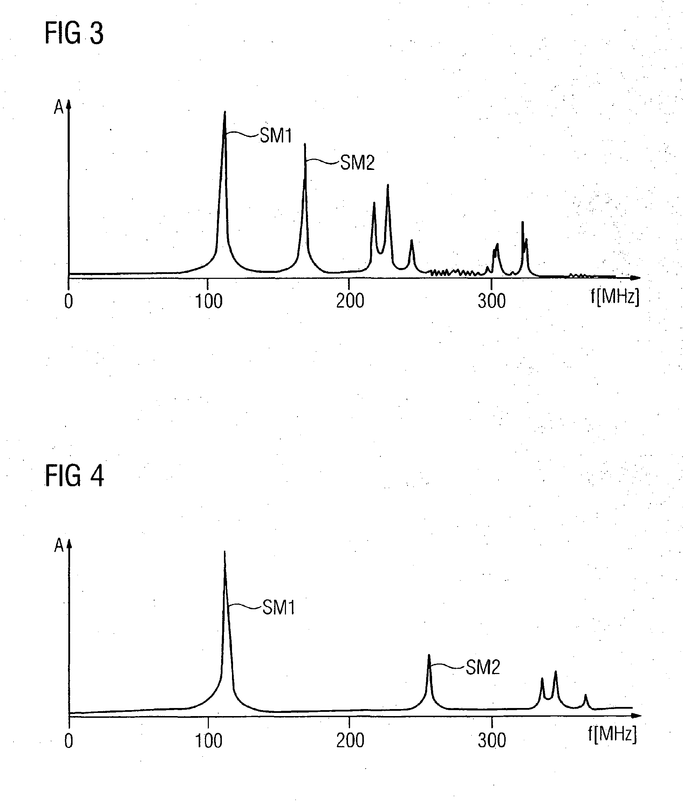

Figur 3 zeigt das Frequenzspektrum des herkömmlichen mikromechanischen Systems gemäß Figur 1. Genauer gesagt handelt es sich bei dem dargestellten Frequenzspektrum um das Ergebnis einer Simulationsrechnung unter Anwendung einer Finite-Elemente-Methode, wobei der Simulationsrechung ein in seinem Aufbau im Wesentlichen der schematischen Darstellung der Figur 1 entsprechendes mikromechanisches System zu Grunde gelegt wurde.

In der Darstellung, in der die Amplitude A der Schwingung des schwingfähigen Systems als Funktion der Frequenz f in kHz aufgetragen ist, ist erkennbar, dass bei dem herkömmlichen mikromechanischen System neben der ersten Eigenmode SM1 bei etwas mehr als 100 kHz eine weitere Eigenmode SM2 bereits bei einer Frequenz etwas oberhalb von 150 kHz auftritt. Diese weitere Eigenmode SM2 ist unerwünscht, da sie zu einer Störung der Funktion des mikromechanischen Systems beziehungsweise zu einer Reduzierung der Empfindlichkeit desselben führt beziehungsweise führen könnte.

Figur 4 zeigt das Frequenzspektrum des erfindungsgemäßen mikromechanischen Systems gemäß dem Ausführungsbeispiel der Figur 2. Genauer gesagt handelt es sich analog zu Figur 3 bei dem dargestellten Frequenzspektrum wiederum um das Ergebnis einer Simulationsrechnung unter Anwendung einer Finite-Elemente-Methode, wobei der Simulationsrechung ein in seinem Aufbau im Wesentlichen der schematischen Darstellung der Figur 2 entsprechendes mikromechanisches System zu Grunde gelegt wurde.

Im Vergleich der Figur 4 mit der Figur 3 wird hierbei überaus deutlich, dass dadurch, dass bei dem erfindungsgemäßen mikromechanischen System 1 gemäß Figur 2 im Innenbereich der seismischen Masse 2 zusätzlich ein weiteres Federelement 7 vorgesehen ist, mittels dessen die seismische Masse 2 an einen weiteren Ankerpunkt 8 des mikromechanischen Systems 1 angebunden ist, eine deutliche Verbesserung der Moden-Separation des schwingfähigen Systems des mikromechanischen Systems 1 erzielt wird. So ist die erste Eigenmode SM1 in ihrer Frequenz im Wesentlichen unverändert. Hingegen tritt nun die weitere Eigenmode SM2 vorteilhafterweise erst oberhalb von etwa 250 kHz auf. Störungen einer Messung durch das mikromechanische System 1 im Bereich der ersten Eigenbeziehungsweise Schwingungsmode SM1 durch die weitere beziehungsweise zweite Schwingungsmode SM2 können somit hierbei vorteilhaf-terweise zuverlässig ausgeschlossen werden.

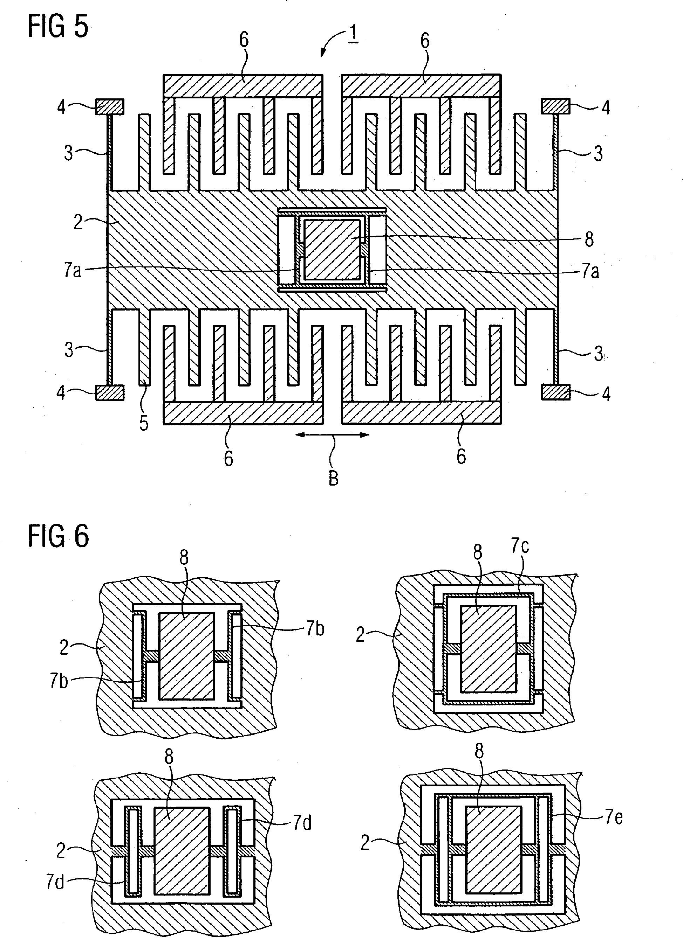

Figur 5 zeigt in einer schematischen Skizze ein weiteres Ausführungsbeispiel des erfindungsgemäßen mikromechanischen Systems. Die Darstellung der Figur 5 entspricht im Wesentlichen derjenigen der Figur 2, wobei im Unterschied zu Figur 2 im Innenbereich der seismischen Masse 2 zwei weitere Federelemente 7a vorgesehen sind, mittels derer die seismische Masse 2 an den weiteren Ankerpunkt 8 des mikromechanischen Systems 1 angebunden ist. Ebenso wie in Figur 2 ermöglicht der Aufbau der Federelemente 3 sowie der weiteren Federelemente 7a hierbei eine geradlinige Bewegung der seismischen Masse 2 in der Bewegungsrichtung B.

Im Vergleich zu der Figur 2 ist die Gesamtsteifigkeit des schwingfähigen Systems bei der Ausführungsform gemäß der Figur 5 deutlich größer. Dies resultiert sowohl aus den als einzelne Federbänder ausgeführten Federelementen 3 an der Außenseite der seismischen Masse 2 als auch aus der Ausprägung der weiteren Federelemente 7a. Darüber hinaus ist der Platzbedarf bei den weiteren Federelementen 7a vorteilhafterweise geringer als bei dem weiteren Federelement 7 der Figur 2.

Generell sei darauf hingewiesen, dass eine Kombination unterschiedlicher Formen von Federn für die Federelemente 3 sowie die weiteren Federelemente 7a möglich ist. Dabei erfolgt die jeweilige Festlegung vorteilhafterweise in Abhängigkeit von dem jeweils vorgesehenen Anwendungsgebiet beziehungsweise der gewünschten Nutzmode, d.h. der für den Betrieb des mikromechanischen Systems gewünschten Eigenfrequenz des schwingfähigen Systems.

Figur 6 zeigt Ausführungsbeispiele weiterer Federelemente des erfindungsgemäßen mikromechanischen Systems. Dargestellt sind weitere Federelemente 7b, 7c, 7d, 7e, die zusammen mit dem jeweiligen weiteren Ankerpunkt 8 jeweils eine Mittenaufhängung der seismischen Masse 2 realisieren.

Die in Figur 6 links oben dargestellte Ausführungsform, die derjenigen der Figur 5 ähnelt beziehungsweise entspricht, weist den Vorteil auf, dass das aus den Federelementen 7b aufgebaute Federsystem eine hohe Steifigkeit sowie einen geringen Platzbedarf aufweist.

Dem gegenüber bietet die Ausführungsform gemäß der Darstellung rechts oben in Figur 6 den Vorteil, dass das weitere Federelement 7c, das in Form einer Bügelfeder ausgebildet ist, eine hohe Steifigkeit aufweist und zugleich besonders ausgeprägt auf eine geradlinige Bewegung in die Bewegungsrichtung hinwirkt. Dies bedeutet, dass das weitere Federelement 7c von der Bewegungsrichtung des schwingfähigen Systems abweichende Schwingungsmoden besonders wirksam unterdrückt.

Die in Figur 6 links unten dargestellte Ausführungsform mit zwei weiteren Federelementen 7d weist hingegen insbesondere den Vorteil einer geringen Materialspannung in den weiteren Federelementen 7d auf.

Die Ausführungsform rechts unten in Figur 6, die derjenigen der Figur 2 ähnelt, stellt in gewisser Weise eine Kombination der beiden zuvor genannten Ausführungsformen dar. So wird durch die Verwendung eines als Bügelfeder ausgebildeten weiteren Federelementes 7e insbesondere wiederum eine geradlinige Bewegung der seismischen Masse 2 beziehungsweise des schwingfähigen Systems des mikromechanischen Systems unterstützt.

Entsprechend den vorstehenden Ausführungen weisen das erfindungsgemäße mikromechanische System sowie das erfindungsgemäße Verfahren insbesondere den Vorteil auf, dass durch das Vorsehen einer Mittenaufhängung der seismischen Masse, d.h. dadurch, dass im Innenbereich der seismischen Masse zusätzlich zumindest ein weiteres Federelement vorgesehen ist beziehungsweise wird, mittels dessen die seismische Masse an einem weiteren Ankerpunkt des mikromechanischen Systems angebunden ist beziehungsweise wird, eine gezielte und wirkungsvolle Beeinflussung der dynamischen Eigenschaften des schwingfähigen Systems des mikromechanischen Systems dahingehend erfolgt, dass die Separation zwischen der im Betrieb des mikromechanischen Systems verwendeten Nutzmode und weiteren Schwingungsmoden des schwingfähigen Systems vergrößert beziehungsweise verbessert wird.

## Patentansprüche

1. Mikromechanisches System (1) mit einem schwingfähigen System, das eine seismische Masse (2) sowie zumindest zwei Federelemente (3) aufweist, wobei die Federelemente (3) jeweils derart einerseits außen an die seismische Masse (2) und andererseits an feststehende Ankerpunkte (4) des mikromechanischen Systems (1) angebunden sind, dass eine Schwingung der seismischen Masse (2) in genau einer Bewegungsrichtung (B) ermöglicht wird, wobei das mikromechanische System als Sensor zur Erfassung von Schallemissionssignalen ausgebildet ist, **dadurch gekennzeichnet, dass** im Innenbereich der seismischen Masse (2) zumindest ein weiteres Federelement (7, 7a, 7b, 7c, 7d, 7e) vorgesehen ist, mittels dessen die seismische Masse (2) an einen weiteren Ankerpunkt (8) des mikromechanischen Systems (1) angebunden ist.

2. Mikromechanisches System nach Anspruch 1,
**dadurch gekenntzeichnet,** dass das schwingfähige System eine Resonanzfrequenz im Ultraschallbereich aufweist.

3. Mikromechanisches System nach Anspruch 1 oder 2,
**dadurch gekenntzeichnet,** dass die Federelemente (3) als Bügelfedern ausgebildet sind.

4. Mikromechanisches System nach einem der vorangehenden Ansprüche,
**dadurch gekennzeichnete, dass** das zumindest eine weitere Federelement (7, 7a, 7b, 7c, 7d, 7e) als Bügelfeder ausgebildet ist.

## Claims

1. Micromechanical system (1) with a system that can vibrate, that has a seismic mass (2) and at least two spring elements (3), wherein the spring elements (3) are respectively fastened on one side externally to the seismic mass (2) and on the other side to fixed anchor points (4) of the micromechanical system (1) such that the seismic mass (2) can vibrate in precisely one movement direction (B), wherein the micromechanical system is embodied as a sensor for detecting acoustic emission signals
**characterised in that**
in the inner region of the seismic mass (2) at least one further spring element (7, 7a, 7b, 7c, 7d, 7e) is provided, by means of which the seismic mass (2) is fastened to a further anchor point (8) of the micromechanical system (1).

2. Micromechanical system according to claim 1,
**characterised in that** the system that can vibrate has a resonant frequency in the ultrasonic range.

3. Micromechanical system according to claim 1 or 2,
**characterised in that**
the spring elements (3) are embodied as bow springs.

4. Micromechanical system according to one of the preceding claims,
**characterised in that** the at least one further spring element (7, 7a, 7b, 7c, 7d, 7e) is embodied as a bow spring.

## Revendications

1. Système micromécanique (1) muni d'un système capable de vibrer comportant une masse sismique (2) ainsi qu'au moins deux éléments ressorts (3), lesdits éléments ressorts (3) étant chacun reliés d'une part à l'extérieur à la masse sismique (2) et d'autre part à des points d'ancrage fixes (4) du système micromécanique (1) de manière à permettre une vibration de la masse sismique (2) dans précisément une direction de déplacement (B), ledit système micromécanique étant réalisé sous forme de capteur destiné à détecter des signaux d'émissions sonores,
**caractérisé en ce que**
au moins un autre élément ressort (7, 7a, 7b, 7c, 7d, 7e) est prévu à l'intérieur de la masse sismique (2), au moyen duquel la masse sismique (2) est reliée à un autre point d'ancrage (8) du système micromécanique (1).

2. Système micromécanique selon la revendication 1,
**caractérisé en ce que**
le système capable de vibrer a une fréquence de résonance dans le domaine des ultrasons.

3. Système micromécanique selon la revendication 1 ou 2,
**caractérisé en ce que**
les éléments ressorts (3) sont réalisés sous forme de ressorts en étrier.

4. Système micromécanique selon l'une des revendications précédentes,
**caractérisé en ce que**
le au moins un autre élément ressort (7, 7a, 7b, 7c, 7d, 7e) est réalisé sous forme de ressort en étrier.
